# EUROPEAN PATENT SPECIFICATION

(11) **EP 1 289 728 B1**
(45) Date of publication and mention of the grant of the patent: **17.01.2007**
(21) Application number: 01948383.3
(22) Date of filing: 14.06.2001
(51) Int. Cl.: B29C 44/34, B29C 44/12, B29C 45/14

(54) **ENCAPSULATION USING MICROCELLULAR FOAMED MATERIALS**
VERKAPSELUNG UNTER VERWENDUNG VON MIKROZELLULÄREN SCHAUMSTOFFEN
ENCAPSULATION AU MOYEN DE MATERIAUX ALVEOLAIRES MICROCELLULAIRES

(30) Priority: 14.06.2000 US 211404 P
(43) Date of publication of application: 12.03.2003
(73) Proprietor: E.I. DUPONT DE NEMOURS AND COMPANY, Wilmington, Delaware 19898 (US)
(72) Inventor: BOYER, Thomas, D., Randleman, North Carolina 27317 (US)
(74) Representative: Morf, Jan Stefan
(86) International application number: PCT/US2001/019190
(87) International publication number: WO 2001/097584

(56) References cited:
- US-A- 4 473 665
- US-A- 4 806 083
- US-A- 5 158 986
- US-A- 5 160 674

## Description

### FIELD OF INVENTION

The field of invention relates generally to the packaging of objects, and more particularly, to encapsulation of electronic and electrical components using microcellular foamed materials.

### BACKGROUND OF INVENTION

Packaging or encapsulation of objects using thermoset or thermoplastic materials is commonly used in the electronic and electrical industries to package components such as wire coils; printed circuits whether rigid, flexible, lead-frame, or molded interconnect device based; semiconductor devices; electrical power cells; and conductive leads or wires within molded shell parts. As used herein, "packaging" or "encapsulation" are used interchangeably and are identical in meaning to terms such as "overmolding" or "insert molding" as understood by one of ordinary skill in the art.

Technical difficulty (design, performance, manufacturing), economic tradeoff (machine productivity, resin price, cycle time, machine cost), and system complexity (secondary operations, and total system costing) all contribute to the most economical choice of encapsulation material. In general, given equal performance characteristics, encapsulation processes using injection molding with thermoplastic materials as disclosed e.g. in US-A-4 806 083, offers the highest productivity and thus the greatest economic benefits.

Injecting molding processes typically are carried out under conditions of high molding temperatures and high injection pressures. Unfortunately, such operating conditions often cause damage to electronic or electrical components or delicate objects to be packaged. Consequently, this creates a loss in performance and process productivity or process fall-out, which in turn makes injection molding encapsulation processes less economically attractive.

It is desirable, therefore, to have injection molding encapsulation processes capable of packaging objects under low temperature and pressure conditions, so as to prevent damage to the objects to be encapsulated.

### SUMMARY OF INVENTION

This invention includes injection molding encapsulation processes for packaging at least one object in microcellular foamed material, comprising the steps of providing a mold having a mold cavity, positioning at least one object in the mold cavity, providing a packaging material, introducing a fluid into the packaging material under conditions sufficient to produce a supercritical fluid-packaging material solution, introducing the solution into the mold cavity, and converting the solution into a microcellular foamed material. Also included are packaged object(s) produced by such processes.

### BRIEF DESCRIPTION OF DRAWING

Figure 1 is a general diagram setting forth a preferred embodiment for carrying out processes according to this invention.
Figure 2 is a general diagram setting forth a preferred embodiment of a mold for use in producing a completely encapsulated object.
Figure 3 is a general diagram setting forth a preferred embodiment of a mold for use in producing a partially encapsulated object.

### DETAILED DESCRIPTION OF PREFERRED EMBODIMENTS

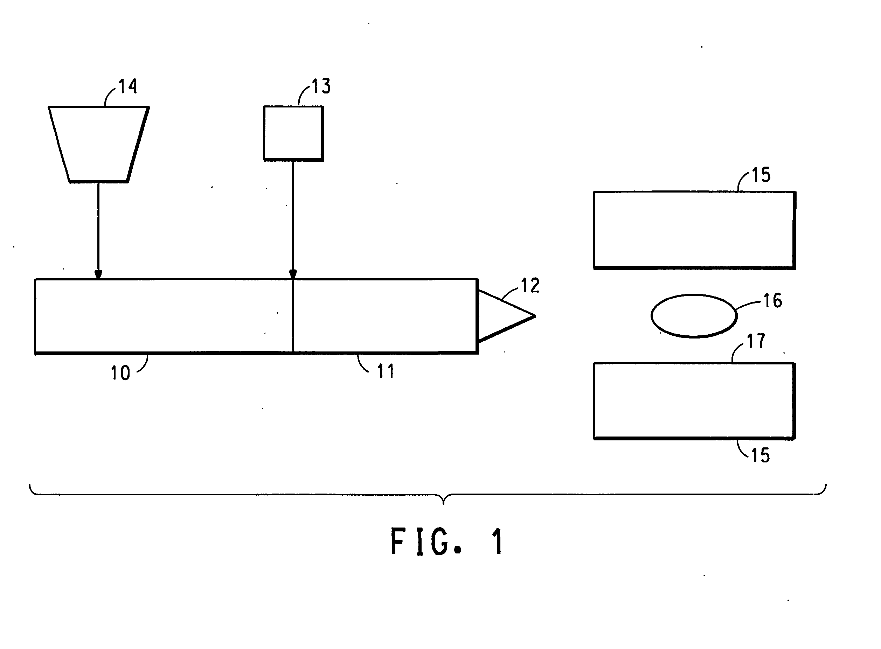

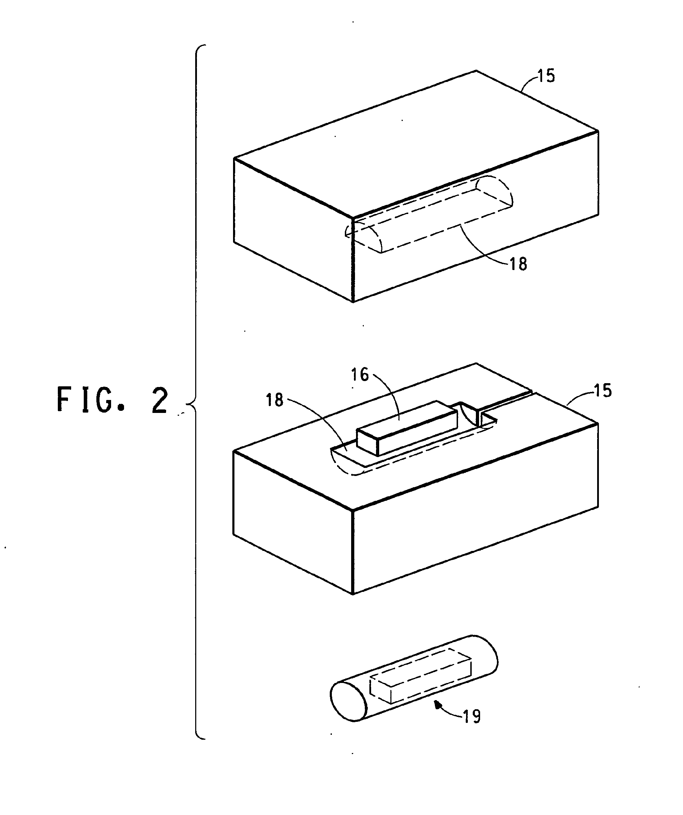

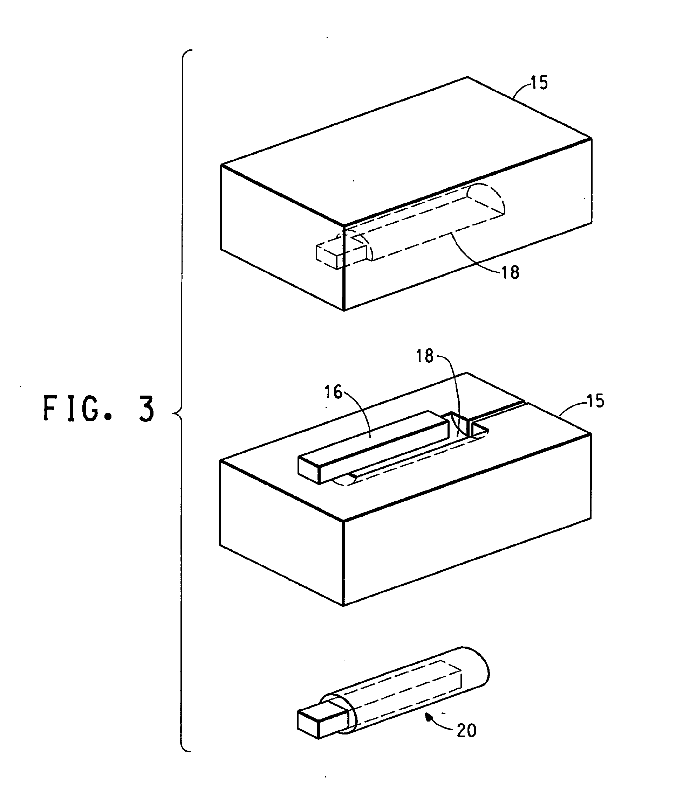

Preferred embodiments for carrying out processes of this invention are best described with reference to Figure 1. Figure 1 exemplifies the following elements:
- 10: barrel and screw of a conventional injection molding device
- 11: retrofit
- 12: nozzle
- 13: fluid supply
- 14: hopper
- 15: mold
- 16: object(s)
- 17: mold surface
In addition to mold 15 and object(s) 16, Figures 2 and 3 exemplify the following elements:
- 18: mold cavity
- 19: completely encapsulated object (Figure 2)
- 20: partially encapsulated object (Figure 3)

Referring to Figures 1-3, an object or objects 16 to be encapsulated is placed inside a mold 15 and more specifically a mold cavity 18 (see Figures 2 and 3). The mold cavity 18 is the area of the mold 15 into which the molten material is allowed to flow and fill. Any conventional mold used in injection molding processes may be employed. Shown here in Figure 1 is a so-called "vertical" clamp mold, which is highly preferred when conducting injection molding encapsulation. Preferably, object(s) 16 is at least one electronic or electrical component. As used herein, an electronic or electrical component includes any component that carries a current when subjected to a voltage, such as a wire coil (e.g., for solenoids, sensors, transformers, motors, torroids, relays, ignition coils), a printed circuit whether rigid, flexible, lead-frame, or molded interconnect device based (e.g., for sensors, controllers, regulators, computer peripheral boards, central processing units), a semiconductor device (e.g., for active, passive, and custom integrated circuits), an electrical power cell (e.g., for battery packs), or an interconnect device, conductive lead or wire, within molded shell parts (e.g., for electrical connection within a molded thermoplastic part).

Referring to Figure 1, object(s) 16 may be supported directly on mold surface 17, and/or supported from the mold surface 17 by tabs (not shown) protruding from object(s) 16, and/or supported by one or more support protrusions (not shown) from the mold cavity(s) (not shown in Figure 1, 18 in Figure 2). Support protrusions from the mold cavity(s) may be stationary or moveable. Moveable support protrusions are especially helpful when creating solid one piece packages which do not expose any portion of the object(s) 16. Use of such tabs and support protrusions are well-known to one of ordinary skill in the art.

Object(s) 16 may be placed completely inside mold cavity 18 (see Figure 2) or only partially within mold cavity 18 (see Figure 3). The former results in the object(s) being completely encapsulated in packaging material, and the latter results in the object(s) being only partially encapsulated. Complete encapsulation is desirable particularly for wireless communication devices or when it is useful to provide an especially effective packaging seal of the object from the environment. Partial encapsulation is desirable particularly with electronic and electrical components, where it may necessary for certain portions of the component to remain exposed for interface with other devices (e.g., for purposes of communicating electrical signals and/or power to and/or from the component).

Figure 2 displays the mold 15, mold cavity 18, and the resulting completely encapsulated object 19, when packaging an object 16 which has been positioned completely within the mold cavity 18. Figure 3 displays the mold 15, mold cavity 18, and the resulting partially encapsulated object 20, when packaging an object 16 which has been positioned partially within the mold cavity 18.

Referring to Figure 1, a preferred machine for carrying out injection molding encapsulation processes of this invention comprises a barrel and screw of a conventional injection molding device 10 that is modified with a retrofit 11 (explained in further detail below) and nozzle 12, which in turn is connected to mold 15 (and mold cavity 18) via known runner and gate systems (not shown).

A hopper 14 provides to the barrel and screw of a conventional injection molding device 10 packaging material to be used to encapsulate object(s) 16. Packaging material is typically provided in the form of solid pellets. Preferably, the packaging material comprises at least one material selected from polyesters, such as polyethylene terepthalate, polybutylene terepthalate, wholly and partially aromatic liquid crystal polymers, and polyether ester polymers; polyacetal; polyamides, such as polyamide 66, polyamide 6, polyamide 46, and polyamide 612; polythalamides; polyphenol sulfones (PPS); polyethylene; polypropylene; acrylonitrile-butadienestyrene (ABS); styrene; vinyl polymers; acrylic polymers; cellulosics; polycarbonates; thermoplastic elastomers (e.g., olefinic, styrenic, urethanes, copolyamides, copolyesters); and blends thereof. Even more preferably, the packaging material comprises any semi-crystalline material or blends thereof. The packaging material will dictate the actual design and operating conditions of the barrel and screw 10 required to adequately melt and process the packaging material. Such design and operating conditions are known to one of ordinary skill in the art.

In preferred embodiments of this invention, a conventional injection molding device 10 is modified with a retrofit 11. In contrast, in a conventional injection molding device 10, retrofit 11 is not present, and the packaging material passes from the barrel and screw 10 through nozzle 12 into the mold 15 (and mold cavity 18). Retrofit 11 comprises a section into which a fluid is introduced from a fluid supply 13 and combined with the packaging material under conditions sufficient to produce a supercritical fluid-packaging material solution, which is subsequently introduced through nozzle 12 into mold 15 (and mold cavity 18).

The fluid supply 13 preferably supplies a supercritical fluid into retrofit 11. Fluid supply 13 may be modified according to techniques readily known to one of ordinary skill in the art to produce a supercritical fluid for introduction into retrofit 11. Alternatively, fluid supply 13 may supply a fluid, preferably gas, into retrofit 11, which in turn is operated under sufficient conditions to transform the fluid into a supercritical fluid.

As used herein, "supercritical fluid" means a material which is maintained at a temperature which exceeds a critical temperature and at a pressure which exceeds a critical pressure, so as to place the material in a supercritical fluid state. In such state, the supercritical fluid has properties which cause it to act, in effect, as both a gas and a liquid. Such temperature and pressure conditions for maintaining materials in a supercritical state are well-known.

Preferably, the supercritical fluid or fluid is carbon dioxide, nitrogen, ethane, ethylene, freon-12, oxygen, ammonia, or water.

In retrofit 11, the packaging material is blended with the supercritical fluid or gas under conditions sufficient to produce a supercritical fluid-packaging material solution. Techniques to achieve such a solution are well-known in the extrusion molding art, as disclosed for example, in U.S. Patent No. 4,473,665; U.S. Patent No. 5,160,674; U.S. Patent No. 5,158,986; U.S. Patent No. 5,334,356; U.S. Patent No. 5,866,053; U.S. Patent No. 6,005,013; and U.S. Patent No. 6,051,174.

Typically, retrofit 11 will extend the screw and barrel region of a conventional injection molding device 10 to include additional sections modified with various mixing elements, such as mixing blades, and/or static mixer sections, designed to effect greater blending of the packaging material and the supercritical fluid. Retrofit 11 may also include a diffusion region in which the mixture of packaging material and supercritical fluid forms a supercritical fluid-packaging material solution, preferably in a single phase.

Throughout retrofit 11, operating conditions should be maintained at sufficient pressures and temperatures to prevent the supercritical fluid from reverting back to a non-supercritical state.

The supercritical fluid-packaging material solution is subsequently introduced into mold 15 through nozzle 12 and known runner and gate systems (not shown) (and into the mold cavity 18). As the supercritical fluid-packaging material solution leaves retrofit 11, particularly through nozzle 12, the resulting drop in pressure creates a thermodynamic instability in the solution, thereby inducing cell nucleation and causing the solution to turn into a microcellular foamed material. Particular nozzle designs for achieving sufficient pressure drops are well-known in the art. Preferably, the nozzle 12 is a positive shut off design. Changes in temperature can also assist in inducing thermodynamic instability. For example, at the end of retrofit 11, it may be desirable to modify the temperature to initiate a controlled cell nucleation process, while still maintaining the pressure at sufficiently high levels to prevent foaming on a wide-scale basis.

Mold 15 and more importantly mold cavity 18 is maintained at a temperature, and if necessary pressure, sufficient to allow the microcellular foamed material to solidify, prior to removal from mold 15. These temperature and pressure conditions will depend upon the packaging material being used and are well-known to one of ordinary skill in the art.

The end result of the above processes is an object(s) 16 that has been encapsulated in a microcellular foamed material. Preferably, the microcellular foamed material has a nuclei density greater than 10⁹ cells/cm³ with a fully grown cell size less than 10µm. More preferably, the microcellular foamed material has a nuclei density between 10¹²-10¹⁵ cells/ cm³ with a fully grown cell size between 0.1-1 µm.

Advantages achieved by processes of this invention are reduced melt viscosity of the supercritical fluid-packaging material solution compared to the packaging material alone, thereby resulting in lower melt temperatures and lower injection pressures. As such, this invention solves the problem of high melt temperatures and high injection pressures common with existing injection molding encapsulation processes, which as discussed above, often damage or displace electronic, electrical or other delicate objects to be encapsulated. Other advantages are reduction or elimination of hold/pack pressure times within the mold, machine downsizing and shortening of cycle time, all of which lead to lower cost manufacturing of the encapsulated devices.

### EXAMPLE

An injection molding encapsulation machine known as an AllRounder 66 ton 320C (available from Arburg, Inc., Newington, CT, USA) was retrofitted with an SCF (Super Critical Fluid) TR10 5000G System (available from Trexel, Inc., Woburn, Massachusetts). The machine was used to encapsulate wound coils using Crastin® SK605 (available from E. I. du Pont de Nemours and Company, Wilmington, Delaware, USA) using nitrogen as the supercritical fluid.

Forty five (45) wound coils were manufactured therefrom with three separate process set-ups, in lots of fifteen (15) coils each. Additionally, twelve (12) wound coils were manufactured using a standard injection molding process as a control. Encapsulated material weight reductions in the test coils were observed from approximately 5% to 27% when compared with the control encapsulated material weight. Resistance levels (in ohms) of the coils were measured before encapsulation and immediately after encapsulation. The rise in resistance level immediately after encapsulation is well known as an indicative measure of the core temperature of the encapsulated wound coil after being released from the mold. In adddition, periodically a measurement of the temperature of the packaging plastic was made shortly after the encapsulated coil was released from the mold, as a confirmation of the resistance measurements. The nominal melt temperature of the thermoplastic was maintained constant by maintaining constant barrel and nozzle temperature settings on the machine throughout the experiment.

Wound coils manufactured using the retrofitted machine demonstrated a reduction in rise of resistance levels and hence a reduction in coil temperature rise, compared to the rise of resistance levels observed in wound coils using a conventional injection molding encapsulation process. This was confirmed with a lower plastic encapsulation temperature as well.

The average resistance of the test coils made using the retrofitted machine was about 4.7 ohms before encapsulation, and about 4.7 ohms (range 4.4 to 5.1 ohms) after encapsulation, depending on the process setup. The plastic packaging temperature ranged between 54°C and 57°C (130F and 135 F), depending on the process setup. In contrast, the average resistance of the control coils was about 4.7 ohms before encapsulation, and about 5.7 ohms after encapsulation. The plastic packaging temperature was observed to range between 57°C and 70 °C (135 F and 158 F).

Injection pressure as measured by the peak hydraulic pressure required to inject the thermoplastic at a constant ram speed of 6.4 cm/sec (2.5"/sec) (a fill rate of 45 cc/sec) was also observed. For the control coils a peak injection pressure average of 6.9 MPa (1000 psi) was observed. For the test coils the peak injection pressure average was 5.8 MPa (840 psi) (860 psi to 800 psi average pressure range) depending upon process set-up. This approximately 15% drop in hydraulic injection pressure was used to confirm a drop in cavity pressure within the mold. The test coils could be molded with clamp force of 10 tons while the control coils needed 40 tons of clamp force.

While this invention has been described with respect to what is at present considered to be the preferred embodiments, it is to be understood that the invention is not limited to the disclosed embodiments. To the contrary, the invention is intended to cover various modifications and equivalent arrangements included within the scope of the appended claims.

## Claims

1. An injection molding encapsulation process for packaging at least one object in microcellular foamed material, comprising the steps of:
providing a mold (15) having a mold cavity (18),
positioning at least one object (16) in the mold cavity;
providing a packaging material;
introducing a fluid into the packaging material under conditions sufficient to produce a supercritical fluid-packaging material solution;
introducing the solution into the mold cavity; and
converting the solution into a microcellular foamed material.

2. The method of Claim 1, wherein the fluid is a supercritical fluid.

3. The method of Claim 1, wherein the fluid comprises carbon dioxide, nitrogen, ethane, ethylene, freon-12, oxygen, ammonia, or water.

4. The method of Claim 1, wherein said converting step and said introducing the solution step are carried out simultaneously.

5. The method of Claim 1, wherein said positioning step comprises positioning at least one object completely in the mold cavity.

6. The method of Claim 1, wherein said positioning step comprises positioning at least one object partially in the mold cavity.

7. The method of claim 1 to 6, wherein said at least one object is at least one electrical or electronic component

8. A packaged object or objects as produced by the process of Claim 1 or 7.

## Patentansprüche

1. Spritzgussverkapselungsverfahren für das Verpacken von mindestens einem Gegenstand in mikrozellulären Schaumstoffen, umfassend die Schritte des:
Bereitstellens einer Form (15) mit einem Formhohlraum (18);
Positionierens mindestens eines Gegenstands (16) in den Formhohlraum;
Bereitstellens eines Verpackungsmaterials;
Einführens eines Fluids in das Verpackungsmaterial unter Bedingungen, die ausreichen, um eine superkritische Fluidverpackungsmateriallösung herzustellen;
Einführens der Lösung in den Formhohlraum; und
Umwandelns der Lösung in ein mikrozelluläres Schaummaterial.

2. Methode nach Anspruch 1, wobei das Fluid ein superkritisches Fluid ist.

3. Methode nach Anspruch 1, wobei das Fluid Kohlendioxid, Stickstoff, Ethan, Ethylen, Freon-12, Sauerstoff, Ammoniak oder Wasser umfasst.

4. Methode nach Anspruch 1, wobei der Umwandlungsschritt und der Schritt des Einführens der Lösung gleichzeitig durchgeführt werden.

5. Methode nach Anspruch 1, wobei der Positionierungsschritt das Positionieren von mindestens einem Gegenstand vollständig in den Formhohlraum umfasst.

6. Methode nach Anspruch 1, wobei der Positionierungsschritt das Positionieren von mindestens einem Gegenstand teilweise in den Formhohlraum umfasst.

7. Methode nach den Ansprüchen 1 bis 6, wobei der mindestens ein Gegenstand mindestens eine elektrische oder elektronische Komponente ist.

8. Verpackter Gegenstand oder verpackte Gegenstände, der bzw. die durch das Verfahren nach Anspruch 1 oder 7 hergestellt wird bzw. werden.

## Revendications

1. Procédé d'encapsulation à moulage par injection en vue de l'emballage d'au moins un objet dans un matériau alvéolaire micro cellulaire, comprenant les étapes:
de mise à disposition d'un moule (15) ayant une cavité de moule (18);
de positionnement d'au moins un objet (16) dans la cavité de moule;
de fourniture d'un matériau d'emballage;
d'introduction d'un fluide dans le matériau d'emballage dans des conditions suffisantes à produire une solution de matériau d'emballage de fluide super-critique;
d'introduction de la solution dans la cavité de moule; et
de conversion de la solution en un matériau alvéolaire micro cellulaire.

2. Procédé selon la revendication 1, dans lequel le fluide est un fluide super-critique.

3. Procédé selon la revendication 1, dans lequel le fluide comprend le dioxyde de carbone, l'azote, l'éthane, l'éthylène, le fréon-12, l'oxygène, l'ammoniac ou l'eau.

4. Procédé selon la revendication 1, dans lequel ladite étape de conversion et ladite étape d'introduction de la solution sont effectuées simultanément.

5. Procédé selon la revendication 1, dans lequel ladite étape de positionnement comprend le positionnement d'au moins un objet complètement dans la cavité de moule.

6. Procédé selon la revendication 1, dans lequel ladite étape de positionnement comprend le positionnement d'au moins un objet partiellement dans la cavité de moule.

7. Procédé selon les revendications 1 à 6, dans lequel ledit au moins un objet est au moins un composant électrique ou électronique.

8. Objet ou objets emballé(s), tel(s) que produit(s) grâce au procédé selon la revendication 1 ou 7.
